# EUROPEAN PATENT SPECIFICATION

(11) **EP 4 203 072 B1**
(45) Date of publication and mention of the grant of the patent: **19.03.2025**
(21) Application number: 22206876.9
(22) Date of filing: 11.11.2022
(51) Int. Cl.: H01L 29/78, H01L 29/417, H01L 29/66, H01L 29/08, H01L 29/10, H01L 27/088

(54) **TRANSISTORS WITH EPITAXIAL SOURCE/DRAIN LINER FOR IMPROVED CONTACT RESISTANCE**
TRANSISTOREN MIT EPITAKTISCHER SOURCE-/DRAIN-AUSKLEIDUNG FÜR VERBESSERTEN KONTAKTWIDERSTAND
TRANSISTORS À REVÊTEMENT DE SOURCE/DRAIN ÉPITAXIAL POUR UNE RÉSISTANCE DE CONTACT AMÉLIORÉE

(30) Priority: 22.12.2021 US 202117559719
(43) Date of publication of application: 28.06.2023
(73) Proprietor: Intel Corporation, Santa Clara, CA 95054 (US)
(72) Inventor: BOMBERGER, Cory, Portland 97225 (US); MURTHY, Anand, Portland 97229 (US); GHANI, Tahir, Portland 97229 (US); NAM, Ju, Hillsboro 97124 (US); BOWONDER, Anupama, Portland 97229 (US)
(74) Representative: Goddar, Heinz J.

(56) References cited:
- EP-A1- 3 648 172
- CN-A- 113 113 408
- US-A1- 2020 006 491
- US-A1- 2020 052 126
- US-A1- 2020 312 842
- US-A1- 2020 350 435
- US-A1- 2021 273 102

## Description

### Technical Field

The disclosure is in the field of advanced integrated circuit structure fabrication and, in particular, 10 nanometer node and smaller integrated circuit structure fabrication and the resulting structures.

### Background

Semiconductor devices are electronic components that exploit the electronic properties of semiconductor materials, such as silicon (Si), germanium (Ge), and silicon germanium (SiGe). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow from the source to the drain. In instances where the charge carriers are electrons, the FET is referred to as an n-channel device, and in instances where the charge carriers are holes, the FET is referred to as a p-channel device. Standard dopant used for Si, Ge, and SiGe includes boron (B) for p-type (acceptor) dopant and phosphorous (P) or arsenic (As) for n-type (donor) dopant. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (p-MOS) and n-channel MOSFET (n-MOS) to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations essentially resides along the three different outer, planar regions of the fin, such a FinFET design is sometimes referred to as a tri-gate transistor. Other types of FinFET configurations are also available, such as so-called double-gate FinFETs, in which the conductive channel principally resides only along the two sidewalls of the fin (and not along the top of the fin).

EP 3 648 172 A1 discloses a semiconductor device is including a semiconductor fin over a substrate, and a gate structure along sidewalls and the top surface of the semiconductor fin. The gate structure covers the first portion of the semiconductor fin. The semiconductor device also includes a source/drain feature adjacent to the gate structure. The semiconductor device further includes a source/drain contact connected to the source/drain feature. The source/drain contact extends downwards to a position that is lower than the top surface of the first portion of the semiconductor fin.

US 2020/350435 A1 discloses a device that includes a fin extending from a substrate, a gate stack over and along sidewalls of the fin, a gate spacer along a sidewall of the gate stack, and an epitaxial source/drain region in the fin and adjacent the gate spacer. The epitaxial source/drain region includes a first epitaxial layer on the fin, the first epitaxial layer including silicon, germanium, and arsenic, and a second epitaxial layer on the first epitaxial layer, the second epitaxial layer including silicon and phosphorus, the first epitaxial layer separating the second epitaxial layer from the fin. The epitaxial source/drain region further includes a third epitaxial layer on the second epitaxial layer, the third epitaxial layer including silicon, germanium, and phosphorus.

US 2020/052126 A1 discloses a semiconductor structure including a gate structure formed over a fin structure and a gate spacer formed on a sidewall surface of the gate structure. The semiconductor structure also includes a first source/drain (S/D) epitaxial layer formed in the fin structure and adjacent to the gate spacer, and a second S/D epitaxial layer formed over the first S/D epitaxial layer. A top surface of the second S/D layer is higher than a top surface of the first S/D epitaxial layer.

US 2020/312842 A1 discloses integrated circuit structures having source or drain structures with vertical trenches. In an example, an integrated circuit structure includes a fin having a lower fin portion and an upper fin portion. A gate stack is over the upper fin portion of the fin, the gate stack having a first side opposite a second side. A first source or drain structure includes an epitaxial structure embedded in the fin at the first side of the gate stack. A second source or drain structure includes an epitaxial structure embedded in the fin at the second side of the gate stack. The epitaxial structures of the first and second source or drain structures have a vertical trench centered therein. The first and second source or drain structures include silicon and a Group V dopant impurity.

US 2021/273102 A1 discloses a device that includes a fin extending from a substrate; a gate stack over and along sidewalls of the fin; a gate spacer along a sidewall of the gate stack; an epitaxial source/drain region in the fin and adjacent the gate spacer, the epitaxial source/drain region including a first epitaxial layer on the fin, the first epitaxial layer including silicon and arsenic; and a second epitaxial layer on the first epitaxial layer, the second epitaxial layer including silicon and phosphorus, the first epitaxial layer separating the second epitaxial layer from the fin; and a contact plug on the second epitaxial layer.

CN 113113408 A discloses a semiconductor device including a fin, a gate stack, a gate spacer, an epitaxial source/drain region, and a contact plug. The fin extends from the substrate; the gate stack is located on the side wall of the fins and along the side wall of the fin; the gate spacer is along the sidewall of the gate stack; the epitaxial source/drain region is located in the fin and adjacent to the gate spacer. The epitaxial source/drain region comprises a first epitaxial layer and a second epitaxial layer. The first epitaxial layer is located on the fin, and the first epitaxial layer comprises silicon and arsenic; the second epitaxial layer is located on the first epitaxial layer, the second epitaxial layer comprises silicon and phosphorus, and the first epitaxial layer separates the second epitaxial layer from the fin; the contact plug is located on the second epitaxial layer.

The present invention is defined by the appended set of claims. Preferred embodiments are defined by the dependent claims.

### Brief Description of the Drawings

The embodiments of the disclosure will be understood more fully from the detailed description given below and from the accompanying drawings of various embodiments of the disclosure, which, however, should not be taken to limit the disclosure to the specific embodiments, but are for explanation and understanding only.
Fig. 1 is a flow chart of a process according an embodiment.
Figs. 2A-2H are cross-sectional views representing various operations in a method of fabricating an integrated circuit structure having source/drain structures including a source/drain liner, in accordance with an embodiment of the present disclosure.
Fig. 3 is a cross-sectional view of another integrated circuit structure
having source/drain structures including a source/drain liner, in accordance with another embodiment of the present disclosure.
Fig. 4 is a cross-sectional view of another integrated circuit structure
having source/drain structures including a source/drain liner, in accordance with another embodiment of the present disclosure.
Fig. 5 is a flow chart of another process according to an embodiment.
Fig. 6 is a cross-sectional side view of an integrated circuit device assembly that may include a cascaded ESOL circuit, in accordance with any of the embodiments disclosed herein.
Fig. 7 is a block diagram of an example electrical device that may include a transistor device, in accordance with any of the embodiments disclosed herein.

### Description of Embodiments

The contact resistance between the source/drain and the contact metal as well as spreading resistance within the source drain will be increased by the small contact areas due to shrinking cell heights. This results in increased external resistance and is exacerbated as dimensions are reduced with scaling. Additionally, alternative channel materials like Si₇₀Ge₃₀ may receive minimal strain from standard compositions for PMOS source drains and tend to receive much of the strain from the substrate.

A fundamental limit in current solutions to address the resistance between the source/drain regions and the contacts in an integrated circuit structure resides in how low the resistance of the source/drain material can go without changing the source/drain material to a metal, which would lead to new issues including introducing a barrier between the channel and the source/drain, as well creating an easy leakage path between the gate and the source/drain contact. Additionally, excessive doping of the top of the source/drain structure can result in the dopant diffusing into the bulk source/drain or even into the channel. This diffused dopant in the source/drain is likely to be inactive, degrade mobility and further increase spreading resistance. The dopants that diffuse into the channel are likely to increase leakage and make any short channel control issues worse.

Moreover, current PMOS source drain materials are typically limited to Si(1-X)GeX:B with X<0.6. The above limit in the Ge content of the SiGe is based on the fact that Ge concentrations above 80% and below 100% with enough boron dopants are challenging to grow. In addition, pure high Ge content source/drain material are very easily etched away from downstream cleans/etches, and susceptible to melting/reflow from downstream thermal processing. This means that alternative material transistors such as SiGe transistors, which get a large amount of strain from the lattice mismatch between the channel and the Si substrate, have a minimal amount of strain being caused by the standard PMOS source/drain scheme.

To address the above problems, during the selective epitaxial deposition of the source/drain material, instead of filling the source/drain trenches with source/drain material, according to an embodiment, only a thin conformal doped layer (liner) is deposited (e.g. a thin SiGe:B layer), followed by a selective (optionally in-situ sacrificial layer (e.g. i-SiGe)) to fill the rest of the source/drain region. When the source/drain region is opened to make the contact structures, the sacrificial intrinsic layer may be selectively etched out resulting in the doped source/drain region being exposed. At this point an optional doped semiconductor layer, such as Ge:B, can be deposited, either as a layer that is conformal with the source/drain liner, or as a structure that substantially fills the source/drain trenches. The contact metal and any silicide layers are then deposited onto the doped source/drain structures.

Advantageously, some embodiments aim to increase the contact area between the metal contact and the source/drain material while reducing the volume of the epitaxial source/drain structure. This change in source/drain shape (from a structure filling the source/drain trenches to a source/drain liner) reduces contact resistance and further reduces the impact of any resistance in the source/drain including spreading resistance. This ultimately leads to an improvement in the external resistance, increased current at operating voltage, and improvement in the transistor's overall performance. Additional layers such as a Ge:B layer can be incorporated (an maintained to the final device) that also help minimize the contact resistance and minimize the work function barrier between the source/drain and the metal. If the second doped semiconductor layer Ge:B is deposited as a full fill, this layer could provide strain to the channel. Note that Ge:B deposited at the typical source drain location in the flow would not survive the downstream etches/cleans nor the downstream thermal processing. Alternatively with the proper metal choice, additional strain could be provided to the channel.

Integrated circuit structures having source/drain structures with a source/drain liner are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Note that the designation "source/drain" is used herein to refer to either a source or a drain or both, as the regions may be similar in the end structure but be differentiated based on how the device is electrically connected.

Some embodiments aim to improve the resistance between the source/drain regions and the metal contact in an integrated circuit structure. Some embodiments achieve the above aim by increasing the contact area between the source/drain region and the contact metal in the integrated circuit structure. Some embodiments may be implemented an integrated circuit structures using channel materials containing SiGe where the SiGe may contain 30% germanium. In such devices, the channel region may get much of the strain present therein from the substrate on to which the channel is supported instead of from the source/drain region. For eight channel material containing even higher percentages of germanium, that is add germanium percentage above 30% for example, the strain imparted to the channel region by the supporting substrate becomes even more significant. Embodiments however are not limited to SiGe containing channel materials, but may be implemented in integrated circuits structures where alternative materials are used in the channel region. Some embodiments described herein may be implemented in a PMOS integrated circuit device structures. Some other embodiments described herein may be implemented in a NMOS integrated circuit device structures.

Some embodiments achieve the improvement in resistance between the source/drain region and it's corresponding metal contact by providing a send source/drain layer or liner, for example by way of deposition. According to some embodiments, instead of immediately filling source/drain trenches with an epitaxial source/drain material, initial source drain liners are deposited, a sacrificial source/drain material is deposited on the liners, the sacrificial source/drain material being removed right before provision of the metal contacts.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

### Terminology.

The following paragraphs provide definitions or context for terms found in this disclosure (including the appended claims):
"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. 112, sixth paragraph, for that unit or component.

"First," "Second," etc. As used herein, these terms are used as labels for nouns that they precede, and do not imply any type of ordering (e.g., spatial, temporal, logical, etc.).

"Inhibit"--As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with one or more embodiments of the present disclosure, silicon germanium (SiGe) channel structures with corresponding epitaxial source/drain (S/D) liner structures are described. In an embodiment, low contact resistance is achieved using source/drain liners to further improve drive current of the SiGe channel transistors.

In an embodiment, following source/drain region etching, a resulting recessed region is provided with a doped epitaxial liner that is conformal to a surface area of the source/drain trenches. Such source/drain liners may provide a relatively lower contact resistance. In an embodiment, such an liner structure further provides increased contact structure surface area, and thus serves to reduce the contact resistivity between a contact metal and a source/drain structure, which ultimately leads to improved performance..

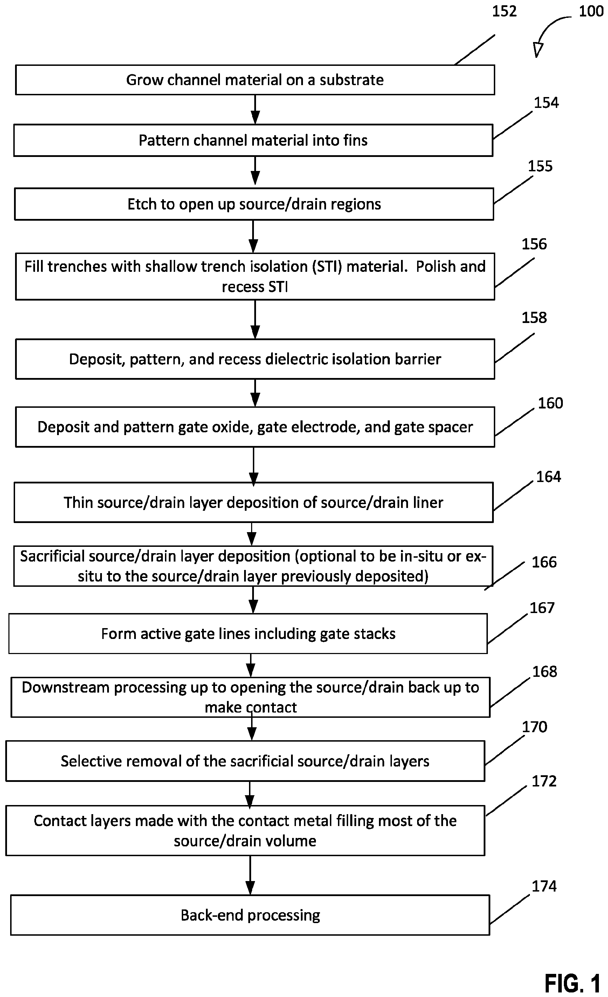

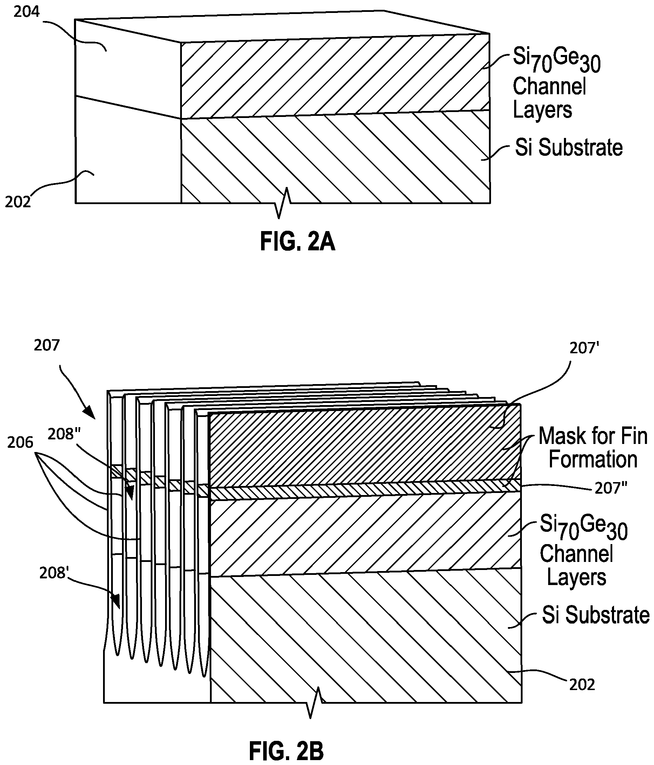

One or more embodiments described herein are directed to fabrication processes and structures including source/drain structures including respective liners grown during a same process as source/drain fabrication, examples of which are described in association with Figs. 1 and 2A-2H described below.

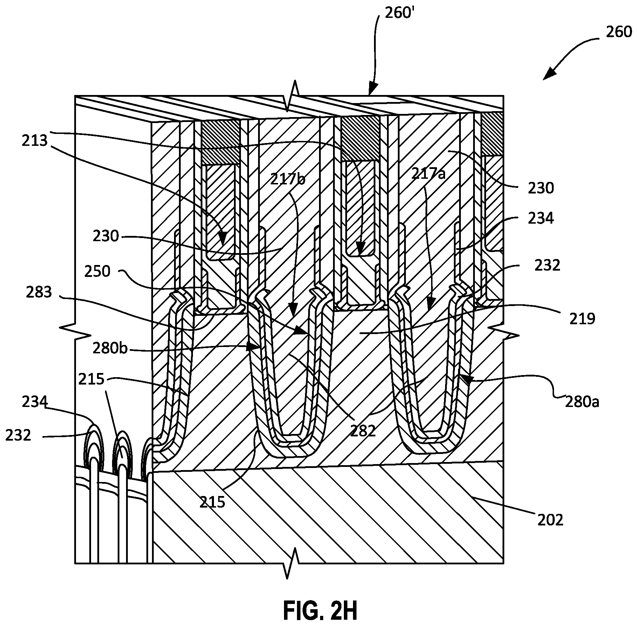

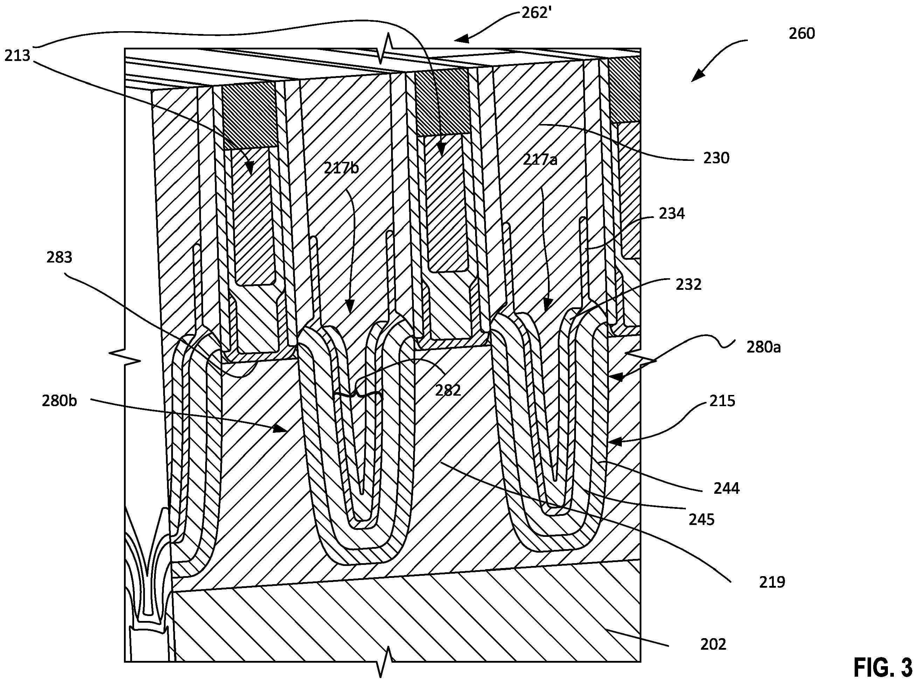

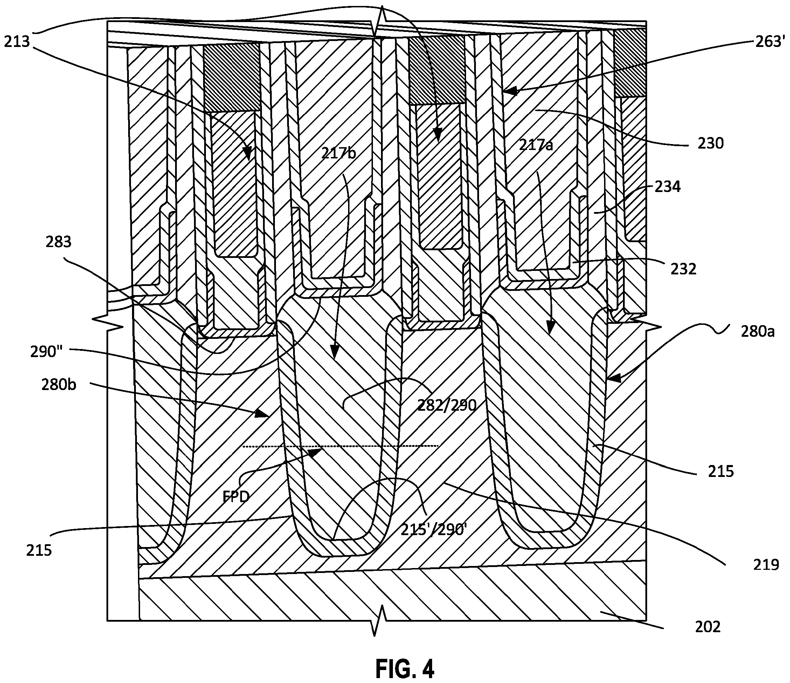

As an exemplary process flow, Fig. 1 is a flowchart representing various operations in a method of fabricating an integrated circuit structure having source or drain structures including source/drain liners, in accordance with an embodiment of the present disclosure. Figs. 2A-2H illustrate cross-sectional views representing various operations in a method of fabricating an integrated circuit structure having source/drain liners, corresponding to operations of the flowchart 100 of Fig. 1, in accordance with an embodiment of the present disclosure. Fig. 2H illustrates a cross-sectional view of an integrated circuit structure having source/drain liners each including a layer of material. Fig. 3 illustrates a cross-sectional view of another integrated circuit structure having source/drain liners each including two layers, in accordance with another embodiment of the present disclosure. Fig. 4 illustrates a cross-sectional view of another integrated circuit structure having source/drain liners and respective germanium fill structures, in accordance with another embodiment of the present disclosure.

Referring to Fig. 2A, and corresponding to operation 152 of flowchart 100 of Fig. 1, a channel layer 204, for example including silicon and germanium, such as Si₇₀Ge₃₀, is grown on a substrate 202, such as a silicon substrate. In one such embodiment, the channel layer 204 may be referred to as a silicon germanium layer or SiGe layer.

Referring to Fig. 2B, and corresponding to operation 154 of flowchart 100 of Fig. 1, channel layer 204 is patterned into fins 206. According to one embodiment, the patterning may form recesses 208' into substrate 202 and openings 208" between fins, as is depicted, although embodiments are not so limited. For example, there could be no recesses 208' in substrate 202. Patterning of the channel layer 204 into fins 206 may be performed in any well-known manner, such as by way of a lithography and etch process using a mask 207, for example including one layer or multiple mask sublayers 207' and 207".

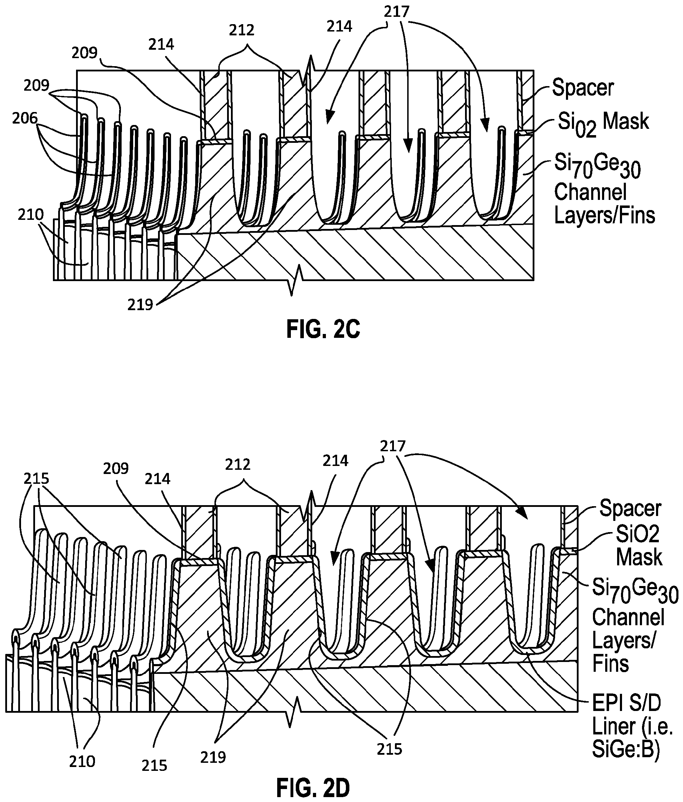

Referring to Fig. 2C, a structure is shown corresponding to implementation of operations 155, 156, 158 and 160 of flowchart 100 of Fig 1.

Per operation 155, after removal of mask 207, a vertical etch (or a vertical etch undercut (EUC) may be performed through the fins 206 in a direction transverse to recesses 208' and to openings 208" between the fins, the EUC to open up source/drain trenches 217 for eventual source/drain structures to be provided therein. In some embodiments, source/drain trenches 217 can be formed using any suitable techniques, such as etching (via wet and/or dry etch processing) fins 206 in the exposed locations.

At operation 156, trenches between the fins 206 are filled with a shallow trench isolation material which is then polished and recessed to form isolation structures 210.

At operation 158, deposition, patterning and recessing of a dielectric isolation barrier 209, such as a dielectric isolation barrier or mask including SiO2, may take place, which barrier may be deposited and patterned on the fins 206.

The process may continue at operation 160 with deposition and patterning of a dummy gate structure 211 including a dummy gate stack 213 and spacers 214. The dummy gate stack may, for example, include polysilicon. Forming the dummy gate structures, in accordance with some embodiments may include forming a dummy gate dielectric (e.g., dummy oxide material) and a dummy gate electrode (e.g., dummy poly-silicon material) to be used for replacement gate processing. In some embodiments, dummy gate structure 212 include any suitable sacrificial material that can be later removed. Dummy gate structure 211, in some embodiments, can be formed using any suitable techniques, such as depositing the material of dummy gate structure 211 and then patterning and etching it to form the structures shown in Fig. 2C. Gate side-wall spacers 214, referred to herein as gate spacers (or simply, spacers) are also formed on either side of the dummy gate structure 211. Such gate spacers 214 can be formed using any suitable techniques, such as depositing the material of gate spacers 214 and performing spacer pattern and etch processing, for example. In some embodiments, the gate spacers 214 are used to help determine the final gate length and/or channel length, and to help with the replacement gate processing. In some embodiments, gate spacers 214 include any dielectric material, such as an oxide (e.g., silicon dioxide), nitride (e.g., silicon nitride), high-k dielectric, low-k dielectric, and/or any other suitable electrically insulating material as can be understood based on this disclosure. In some embodiments, gate spacers 214 include silicon, oxygen, nitrogen, and/or carbon. For instance, in some embodiments, gate spacers 214 include silicon dioxide, silicon monoxide, silicon nitride, silicon oxynitride, or carbon-doped silicon dioxide (or other carbon-doped oxides). In some embodiments, it is desired to select material for gate spacers 214 that has a low dielectric constant and a high breakdown voltage. In some embodiments, gate spacers 214 include a multilayer structure (e.g., a bilayer structure where the sub-layers are laterally adjacent to each other).

According to one option, the fins 206 may be further etched down to expose locations for source/drain material deposition, although not shown in Figs. 2A-2H.

It is after the operation associated with Fig. 2C that example embodiments diverge with respect to the state of the art, from Fig. 2D to Fig. 2H.

Referring to Fig. 2D, and corresponding to operation 164 of Fig. 1, source/drain liners 215 may be provided on the fins 206 in the source/drain trenches 217. The liners 215 may include a boron-doped epitaxial material, such as a boron doped SiGe material for a PMOS transistor, and a phosphorus doped SiGe material for a NMOS transistor. The Ge atomic percentage of a SiGe material used for the liners may be about 50% or more. For NMOS transistors, the dopant may be controlled to obtain improved contact resistance without increased possibility of dopant diffusion into the channel regions 219. A reason for the above is that NMOS dopants may diffuse more readily than PMOS dopants, and hence, the provision of doped liners in the source/drain regions of an integrated circuit structure according to embodiments may be easier to achieve for PMOS transistors than for NMOS transistors.

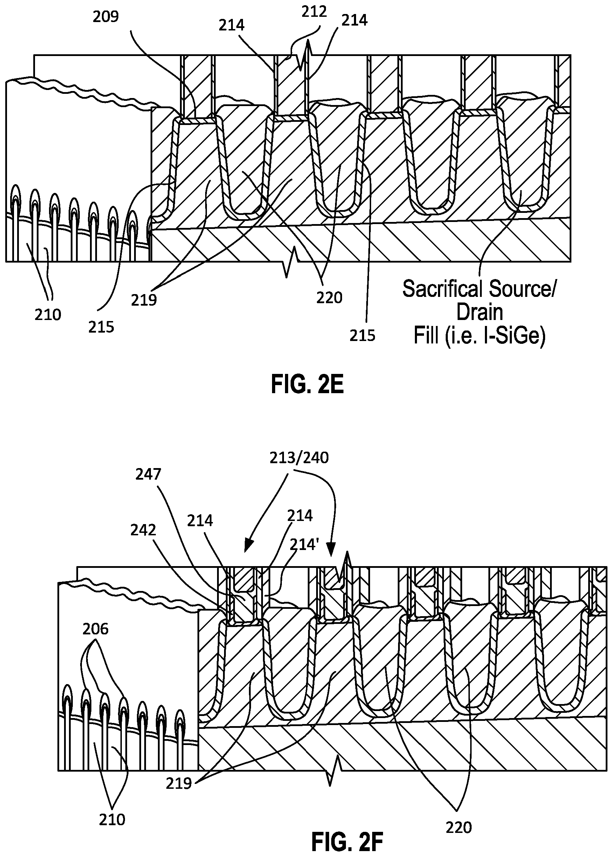

In some embodiments, source/drain material of liners 215 can be epitaxially selectively grown as semiconductor material from the outer portions of fins 206. Source/drain material of liners 215, in some embodiments, include semiconductor material. A feature of a material for the liners 215 is that is may be selected to withstand temperatures, such as anneal temperatures, associated with gate structure formation subsequent to a filling of the source/drain trenches, as will be explained in further detail in relation to Fig. 2F below.

In some such embodiments, source/drain material of liners 215 include group IV or group III-V semiconductor material. In some embodiments, source/drain material of liners 215 include one or more of silicon, germanium, tin, carbon, indium, gallium, aluminum, arsenic, nitrogen, phosphorous, arsenic, or antimony. In some embodiments, source/drain material of liners 215 includes the same group-type of semiconductor material that channel layers formed by fins 206 include. For instance, in some such embodiments where channel layers of fins 206 include group IV semiconductor material (e.g., Si, SiGe, Ge), source/drain material of liners 215 also include group IV semiconductor material. Further, in some embodiments where channel layers of fins 206 include group III-V semiconductor material (e.g., GaAs, InGaAs, InP), source/drain material of liners 215 also include group III-V semiconductor material. However, in other embodiments, one of channel layers of fins 206 or source/drain material of liners 215 include group IV semiconductor material, and the other of channel layers of fins 206 or source/drain material of liners 215 include group III-V semiconductor material. The liners include silicon. In another example embodiment, source/drain material of liners 215 include indium, such as InGaAs.

In some embodiments, the semiconductor material included in source/drain material of liners 215 includes dopant, such as a p-type dopant for a PMOS transistor device. The source/drain material of liners 215 may include Si or SiGe with a relatively low Ge concentration (e.g., 0-30 atomic percent), or a SiGe or Ge with a relatively high Ge concentration (e.g., 30-100 atomic percent).

Alternatively, as an alternative to selective deposition of the source/drain liners, the source/drain liners 215 may be deposited using a cyclic etch process over the SiGe fins and on the STI regions and spacers 214, although but the deposition on top of the fins would yield a crystalline liner, and would therefore grow faster than deposition on non-fin regions of the structure. Blanket deposition of liner material over the STI regions for example would result in an amorphous material that grows more slowly than the crystalline material on the fins, resulting in a thinner amorphous layer on the STI regions or spacers. As a result, a subsequent etch of the deposited liner material would result in an etch which proceeds yields different results as between the liner remaining on the fin regions (a thicker crystalline liner) as compared with the STI or spacer regions (where the deposited liner material could be substantially entirely etched away).

Referring to Fig. 2E, and corresponding to operation 166 of flowchart 100 of Fig. 1, a sacrificial source/drain structure 220 formation involves deposition of a sacrificial source/drain material in trenches 217, the sacrificial source/rain structures 220 adhering to the liners in the source/drain regions as defined by trenches 217, and further adhering to top surfaces of the STI regions 210 in between the fins 206. In an embodiment, provision of the sacrificial source/drain structures may be performed in situ (i.e. in the same tool as the one used to provide the liners 215, for example by depositing a material such as intrinsic silicon, or intrinsic SiGe, or another intrinsic material that could later be etched away. In another embodiment, the provision of the sacrificial source/drain structures may be performed ex-situ. The sacrificial source/drain material is not limited to crystalline materials, and could include any suitable material that could be etched away, preferably in a manner selective to the material of the liners.

Where an intrinsic SiGe is deposited as the sacrificial source/drain material, its germanium content may be different from the germanium content of the doped liner region 215. Where the channel is made of a group IV material, some embodiments envisage the use of any group IV material for the sacrificial source/drain material as well. The latter may be easier to achieve in-situ in a tool where, for example, boron doped SiGe may have already been provided for the channel material, for example by way of chemical vapor deposition. Preferably, the sacrificial source/drain material has a composition that is significantly different from that of the liner, so that the etch for the sacrificial source/drain material would be selective to the material of the liner and therefore not etch away the same. Therefore, for a PMOS integrated circuit structure, by way of example, where a boron doped SiGe material is provided for the material of the liner, a sacrificial source/drain material that is made of intrinsic silicon may be preferable. Furthermore, for a NMOS integrated circuit structure, by way of example, where a phosphorus doped silicon material is used for the liner, the sacrificial source/drain material may include a higher germanium content SiGe, such as maybe a 30%-40% germanium SiGe material, which would be easier to remove while being selective to the phosphorus doped silicon liner. The above material combinations between the sacrificial source/drain material and the liner material may provide options for an in situ deposition solution using, for example, a CVD tool.

Alternatively, the sacrificial source/drain material may include a combination of silicon, oxygen, and nitrogen, optionally with carbon. Such sacrificial source/drain materials may be deposited quite thickly, at different selectable hardnesses and densities. For example, the sacrificial source/drain material may include any material that may be used for as a ILD material during gate formation, such as one or more dielectrics, such as one or more oxides (e.g., silicon dioxide), nitrides (e.g., silicon nitride), high-k dielectrics, low-k dielectrics, and/or any other suitable electrically insulating material as can be understood based on this disclosure. In some embodiments, the sacrificial source/drain material may include silicon dioxide, silicon monoxide, silicon nitride, silicon oxynitride, or carbon-doped silicon dioxide (or other carbon-doped oxides).

Referring to Fig. 2F, and correspond to operation 167 of Fig. 1, a plurality of active gate lines 240 is formed over semiconductor fins. The active gate lines 240 include a gate dielectric structure 242 (e.g. a high-k dielectric structure), a fill gate electrode portion 247 (e.g. metal gate). Dielectric spacers 214 provide sidewalls of the active gate lines 240.

Gate dielectric, in some embodiments, includes one or more dielectrics, such as one or more oxides (e.g., silicon dioxide), nitrides (e.g., silicon nitride), high-k dielectrics, low-k dielectrics, and/or any other suitable material as can be understood based on this disclosure. Examples of high-k dielectrics include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. Examples of low-k dielectrics include, for instance, fluorine-doped silicon dioxide, carbon-doped silicon dioxide, porous silicon dioxide, porous carbon-doped silicon dioxide, spin-on organic polymeric dielectrics (e.g., polytetrafluoroethylene, benzocyclobutene, polynorbornenes, polyimide), spin-on silicon based polymeric dielectrics (e.g., hydrogen silsesquioxane, methylsilsesquioxane), to provide some examples. In some embodiments, an annealing process is carried out on the gate dielectric to improve its quality when, for example, high-k dielectric material is employed.

In some embodiments, the gate dielectric includes oxygen. In some such embodiments where the gate dielectric includes oxygen, the gate dielectric also includes one or more other materials, such as one or more of hafnium, silicon, lanthanum, aluminum, zirconium, tantalum, titanium, barium, strontium, yttrium, lead, scandium, zinc, lithium, or niobium. For instance, the gate dielectric may include hafnium and oxygen (e.g., in the form of hafnium oxide or hafnium silicon oxide), or the gate dielectric may include silicon and oxygen (e.g., in the form of silicon dioxide, hafnium silicon oxide, or zirconium silicon oxide), in accordance with some embodiments. In some embodiments, the gate dielectric includes nitrogen. In some such embodiments where the gate dielectric includes nitrogen, the gate dielectric may also include one or more other materials, such as silicon (e.g., silicon nitride) for instance. In some embodiments, the gate dielectric includes silicon and oxygen, such as in the form of one or more silicates (e.g., titanium silicate, tungsten silicate, niobium silicate, and silicates of other transition metals). In some embodiments, the gate dielectric includes oxygen and nitrogen (e.g., silicon oxynitride or aluminum oxynitride).

Gate electrode, in some embodiments, includes one or more metals, such as one or more of aluminum, tungsten, titanium, tantalum, copper, nickel, gold, platinum, ruthenium, or cobalt, for example. In some embodiments, the gate electrode includes carbon and/or nitrogen, such as in combination with one or more of the metals in the preceding sentence, for example. For instance, in some embodiments gate electrode includes titanium and nitrogen (e.g., titanium nitride), or tantalum and nitrogen (e.g., tantalum nitride), such as in a liner layer that is in direct contact with the gate dielectric, for example. Thus, in some embodiments, the gate electrode includes one or more metals that may or may not include one or more other materials (such as carbon and/or nitrogen). In some embodiments, the gate electrode includes a multilayer structure, including two or more compositionally distinct layers. For instance, in some such embodiments, one or more work function layers are employed, such as one or more metal-including layers that are formed with desired electrical characteristics. Further, in some such embodiments, the one or more metal-including layers include tantalum and/or titanium, which may also include nitrogen (e.g., in the form of tantalum nitride or titanium nitride).

In some embodiments, the gate electrode includes a resistance reducing metal layer between a bulk metal structure and the gate dielectric, for instance. Example resistance reducing metals include, for instance one or more of nickel, titanium, titanium with nitrogen (e.g., titanium nitride), tantalum, tantalum with nitrogen (e.g., tantalum nitride), cobalt, gold, gold with germanium (e.g., gold-germanium), nickel, platinum, nickel with platinum (e.g., nickel-platinum), aluminum, and/or nickel with aluminum (e.g., nickel aluminum), for instance. Example bulk metal structures include one or more of aluminum, tungsten, ruthenium, copper, or cobalt, for instance. In some embodiments, the gate electrode includes additional layers, such as one or more layers including titanium and nitrogen (e.g., titanium nitride) and/or tantalum and nitrogen (e.g., tantalum nitride), which can be used for adhesion and/or liner/barrier purposes, for example. In some embodiments, the thickness, material, and/or deposition process of sub-layers within a multilayer gate electrode are selected based on a target application, such as whether the gate electrode is to be used with an n-channel device or a p-channel device. In some embodiments, the gate electrode provides means for changing the electrical attributes of each adjacent channel layer 206 when a voltage is applied to the gate electrode.

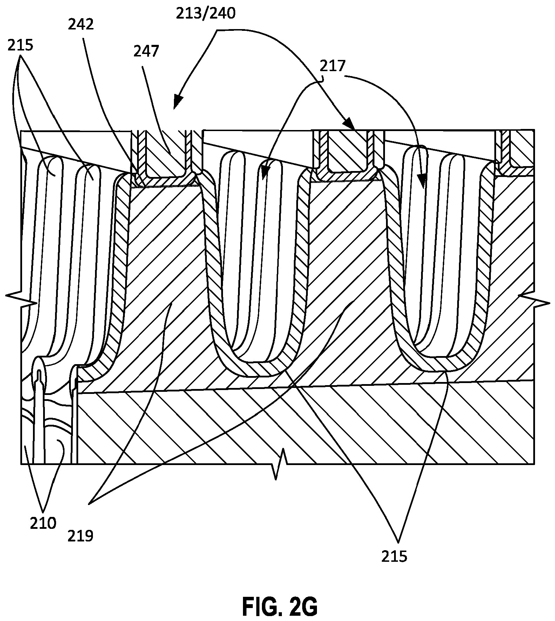

Referring to Fig. 2G, and corresponding to operations 168 and 170 of flowchart 100 of Fig. 1, contact opening are provided for the source/drain regions. The sacrificial source/drain material may be etched using any well known method, such as by way of a timed selective etch.

Referring to Fig. 2H, and corresponding to operation 172 of flowchart 100 of Fig. 1, source/drain contact material deposition and patterning is performed to form conductive contact structures 230. It is to be appreciated that, following with operation 572 of flowchart 100 of Fig. 1, contacts and back end processing may then be performed. In Fig. 2H, the contact metal is assuming the location usually occupied by a source/drain structure.

The contact metal may be selected to enhance compressive strain on the channel regions.

In some embodiments, the source/drain contact structure formation includes forming source/drain contact trenches in dielectric or ILD layer 270 via etch processing in which the source/drain contact structures 230 can be formed. In some such embodiments, dielectric or ILD layer 270 is completely removed between gate spacers 214 and above source/drain contact structures 230, such as is shown in Figs. 9A/9B/9C. However, in other embodiments, a portion of dielectric layer 270 may remain between the gate spacers 214.

Source/drain contact structures 230, in some embodiments, include one or more metals. For instance, one or both of source/drain contact structures may include a metal, such as a resistance reducing metal and a contact plug metal, or just a contact plug, for instance. Example contact resistance reducing metals include, for instance, nickel, titanium, titanium with nitrogen (e.g., in the form of titanium nitride), tantalum, tantalum with nitrogen (e.g., in the form of tantalum nitride), cobalt, gold, gold-germanium, nickel-platinum, nickel aluminum, and/or other such resistance reducing metals or alloys. Example contact plug metals include, for instance, aluminum, tungsten, ruthenium, or cobalt, although any suitable conductive material could be employed. In some embodiments, additional contact material layers are present in the source/drain contact trenches, for example, titanium, titanium with nitrogen (e.g., in the form of titanium nitride), tantalum, and/or tantalum with nitrogen (e.g., in the form of tantalum nitride).

In the shown embodiment of Fig. 2H, the contact structures 230 include a contact metal, a titanium liner 232 adjacent the source/drain liner 215, and a titanium nitride layer 234 adjacent to and conformal with the titanium liner 232.

Contact materials may be deposited using one or more of chemical vapor deposition (CVD), plasma enhanced chemical vapor deposition (PECVD), atomic layer deposition (ALD), conductive contact fabrication, or thin films. Particular embodiments may include the fabrication of a titanium or like metallic layer using a low temperature (e.g., less than 500 degrees Celsius, or in the range of 400-500 degrees Celsius) chemical vapor deposition of a contact metal to provide a conformal source or drain contact. Implementation of such a conformal source or drain contact may improve three-dimensional (3D) transistor complementary metal oxide semiconductor (CMOS) performance. Metal to semiconductor contact layers may also be deposited using sputtering.

The provision of liners 215 as shown in Fig. 2F makes available a larger surface area for contact material deposition. The resulting greater contact area may reduce the resistance of the junction. Embodiments may include deposition on semiconductor surfaces having a non-flat topography, where the topography of an area refers to the surface shapes and features themselves, and a non-flat topography includes surface shapes and features or portions of surface shapes and features that are non-flat, i.e., surface shapes and features that are not entirely flat. Such conformal deposition may be used to increase the available area of metal semiconductor contact and reduce resistance, improving the performance of the transistor device.

It is to be appreciated that a variety of integrated circuit structures may be fabricated using an integration scheme involving a metallic layer deposition process as described herein. In accordance with an embodiment of the present disclosure, a method of fabricating an integrated circuit structure includes providing a substrate in a chemical vapor deposition (CVD) chamber having an RF source, the substrate having a feature thereon. The method also includes reacting titanium tetrachloride (TiCl.sub.4) and hydrogen (H.sub.2) to form a titanium (Ti) layer on the feature of the substrate. In an embodiment, the titanium layer has a total atomic composition including 98% or greater of titanium and 0.5-2% of chlorine. In alternative embodiments, a similar process is used to fabricate a high purity metallic layer of zirconium (Zr), hafnium (Hf), tantalum (Ta), niobium (Nb), or vanadium (V).

In accordance with an embodiment of the present disclosure, the feature of the substrate is a source or drain contact trench exposing a semiconductor source or drain structure. The titanium layer (or other high purity metallic layer) is a conductive contact layer for the semiconductor source or drain structure.

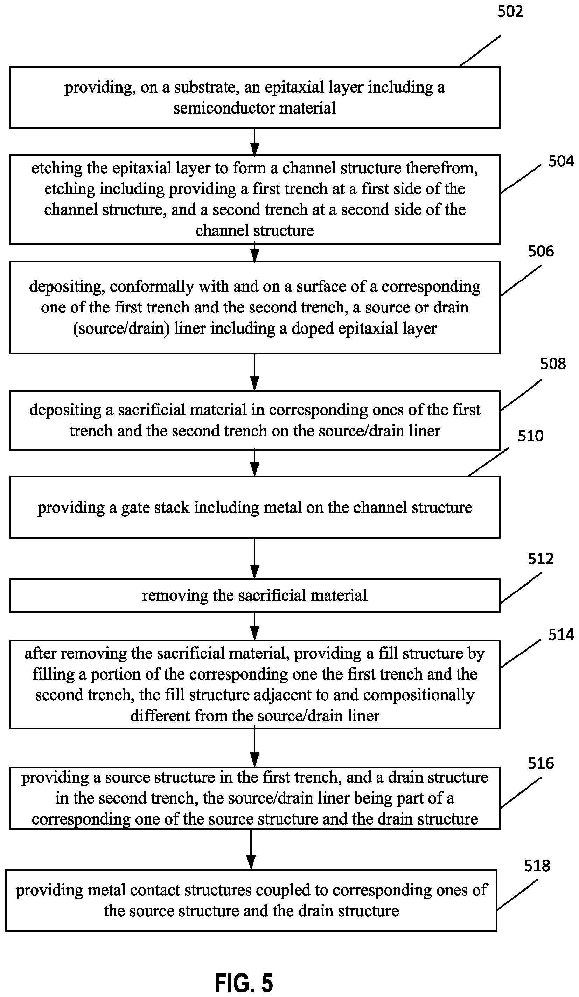

Referring to Fig. 3, and corresponding to an extra operation (not shown in Fig. 5) between operations 170 and 172 of flowchart 100 of Fig. 1, at contact deposition, prior to depositing the contact metal, a doped epitaxial layer 245 may be deposited on the liners to fill the source/drain trenches 217 in order to further boost contact resistance. For example, for a PMOS integrated circuit structure, a layer 245 of boron doped germanium may be epitaxially deposited on the source/drain liner, for example through selective deposition prior to contact metal fill. Providing a doped epitaxial layer onto the liner, may, as suggested in Fig. 3, maintain the benefits of enhanced contact area between the contact material and the source/drain material, while further enhancing such benefits with additional benefits of a pure doped epitaxial contact material.

Referring to Fig. 4, and corresponding to an extra operation (not shown in Fig. 5) between operations 170 and 172 of flowchart 100 of Fig. 1, at contact deposition, prior to depositing the contact metal, a doped epitaxial material 245 may be deposited on the liners to fill the source/drain trenches 217 in order to further boost contact resistance. For example, for a PMOS integrated circuit structure, boron doped germanium may be epitaxially deposited on the source/drain liner, for example through selective deposition, in order to fill the source/drain trenches. Providing a doped epitaxial material onto the liner, may, as suggested in Fig. 3, enhanced compressive straining of a SiGe channel by way of the boron doped germanium material, while further enhancing such benefits with additional benefits of a pure doped epitaxial contact material.

Existing flows may not readily allow direct deposition (as a main epitaxial material) of boron doped germanium in the source/drain trenches 217. Anneals, such as activation or reliability verification anneals, performed subsequent to provision of a directly deposited (without a liner) boron doped germanium material in the source/drain trenches 217, but before or during provision of the gate stacks, may potentially damage the germanium. In addition, standard wet cleans that may be used subsequent to source/drain trench fill and prior to the provision of contact materials may lead to a substantial etch out of such germanium material. The embodiments of Figs. 2 and 3 circumvent the above issue by the provision of the liner material and of the sacrificial source/drain material, followed by provision of the gate stacks, followed by provision of a boron doped germanium material on the liners.

According to some embodiments, liners 215 may include Si, and may include Ge from about 0 to less than 30%. A boron doped germanium layer may then be provided on the liners (as in Figs. 2 and 3). According to an embodiment, the liners 215 may include Si, and a structure adjacent the liners in respective source/drain regions may include less than or equal to about 5% silicon. According to an embodiment, the liners 215 may include Si, and a structure adjacent the liners in respective source/drain regions may include SiGe with a percentage Ge of over 40%. According to some embodiments, a doping percentage of the structure in the source/drain regions increases in a direction from a deepest portion of the source/drain regions toward the contacts. According to some embodiments, the material of the liners is compositionally different from and in the same semiconductor group as the material of the fill structure 282. Therefore, where the material of the liner is a group IV semiconductor material, the material of the fillers is also a group IV semiconductor material, but one that is compositionally different from that of the liners. Therefore, where the material of the liner is a group III-V semiconductor material, the material of the fillers is also a group III-V semiconductor material, but one that is compositionally different from that of the liners.

Where the material of the liners is a group III-V semiconductor material, it may be doped with beryllium for a PMOS integrated circuit structure, or doped with silicon for a NMOS semiconductor structure. The group III-V material may include gallium arsenide, indium gallium arsenide, indium aluminum gallium arsenide, to name some examples. Or instead of arsenic, you can do and to antimony or bismuth.

As shown by way of the example of Figs. 2A-2H, 2 and 3, according to embodiments, an epitaxial source/drain liner would be grown during the typical source/drain growth, except that only a thin doped source/drain material layer would be deposited, and the rest of the typical source drain volume would be filled with a second material (sacrificial) that can be etched out leaving the doped source/drain material behind.

An example embodiment involves depositing a thin highly doped SiGe:B film where the Ge is nearly 50% for the source/drain liners, and filling the rest of the source/drain volume within source/drain trenches with nominally intrinsic SiGe (i-SiGe) with a Ge content of about 30% as the sacrificial source/drain material. Note that the sacrificial source/drain material could be deposited in-situ to the active source/drain or could be deposited ex-situ on another tool, similar to other spacer layers.

The fabrication of the transistor would then continue as normal until right after the source/drain is opened back up (by etching away an interlayer dielectric deposited over the sacrificial source/drain material) to provide contact structures. At this time an additional etch is used to remove the sacrificial layer, in the example above the i-SiGe would be removed, leaving behind the source/drain liners. Thereafter, typical contact layers (Ti, TiN, and contact metal) are deposited into the source drain volume, optionally, with most of the volume being filled with the contact metal. Alternatively a second semiconductor source/drain layer such as boron doped germanium could be deposited in the source/drain trenches, either filling it completely, or providing another conformal layer onto the liners, followed by the typical contact layers.

The presence of the source/drain liners according to some embodiments may be visible in a transmission electron microscopy (TEM) of the source/drain region. In a TEM, some embodiments may exhibit a thin epitaxial doped source/drain material next to the channel and the contact metal filling in the rest of the source/drain trenches adjacent the thin material. The above is distinguishable from a typical FIN-FET structure that has the source/drain trenches filled with epitaxial doped source/drain material such as SiGe. Advantageously, since the liner material of embodiments is preserved by the selective removal of the sacrificial source/drain material, embodiments do not require a spacer material or extra patterning to block the etch of the liner. This means that with a good conformal silicide formation, both the inside of the source/drain liner and the top of the source/drain liner are covered with silicide, providing the largest contact area possible.

Embodiments may advantageously be used for both N and P type source/drains as well as on CMOS devices. Embodiments may also advantageously be used with a variety of channel materials including: strained and unstrained Si, strained and unstrained SiGe, Ge, Sn containing channels, and III-V channels. Embodiments are further applicable to gate first or gate last process flows.

Additionally, embodiments may advantageously be used on a variety of architectures including: planar transistors, FinFETS, TFETs, stacked CMOS, gate-all-around transistors and architectures where the backend contacts are made from the backside for the wafer though a via.

Referring back to Figs. 2H, 3 and 4, some embodiments include an integrated circuit (IC) structure 260/262/263 including: a substrate 202; a transistor device 260'/262'/263' on the substrate, the transistor device comprising; a channel structure corresponding to channel regions 219 including a semiconductor material; a gate stack 213 including a metal, the gate stack on the channel structure; a source structure 280a in a first trench 217a at a first side of the gate stack; a drain structure 280b in a second trench 217b at a second side of the gate stack; individual ones of the source structure and the drain structure including a source or drain (source/drain) liner 215 comprising a doped epitaxial layer conformal with a surface of a corresponding one of the first trench and the second trench; and a fill structure 282 filling a portion of a corresponding one the first trench and the second trench, the fill structure adjacent to and compositionally different from the source/drain liner 215; and metal contact structures 230 coupled to respective ones of the source structure and the drain structure.

As seen in the embodiment of Fig. 3, the doped epitaxial layer is a first doped epitaxial layer 244, the source/drain liner 215 including a second doped epitaxial layer 245 disposed on, conformal with and compositionally different from the first doped epitaxial layer 244. The first doped epitaxial layer 244 may include boron doped silicon germanium, and the second doped epitaxial layer 245 may include boron doped germanium with an atomic percentage of silicon that is from 0% to 5%..

According to some embodiments, as seen in Figs. 2H and 3, individual ones of the metal contact structures 230 include the fill structure 282 and extend into corresponding ones of the first trench 217a and the second trench 217b to a depth below a lower surface 283 of the gate stack. As seen in Figs. 1H and 2,, individual ones of metal contact structures 230 extend into corresponding ones of the first trench and the second trench such that they are adjacent to the source/drain liner 215.

According to some embodiments, as seen in Fig. 4, individual ones of the source structure 280a and the drain structure 280b include the fill structure 282, the fill structure 282 including a doped epitaxial structure 290 disposed on the source/drain liner 215, the doped epitaxial structure 290 having a lower surface 293 conformal with an upper surface 215' of the doped epitaxial layer 215, and an upper surface 290" that is above a fifty percent depth location FPD of the corresponding one of the first trench 217a or the second trench 217b.

Fig. 5 is a flow chart of a process 500 to fabricate an integrated circuit structure according to some embodiments. At operation 502, the process includes providing, on a substrate, an epitaxial layer including a semiconductor material. At operation 504, the process includes etching the epitaxial layer to form a channel structure therefrom, etching including providing a first trench at a first side of the channel structure, and a second trench at a second side of the channel structure. At operation 506, the process includes depositing, conformally with and on a surface of a corresponding one of the first trench and the second trench, a source or drain (source/drain) liner comprising a doped epitaxial layer. At operation 508, the process includes depositing a sacrificial material in corresponding ones of the first trench and the second trench on the source/drain liner. At operation 510, the process includes providing a gate stack including metal on the channel structure. At operation 512, the process includes removing the sacrificial material. At operation 514, the process includes after removing the sacrificial material, providing a fill structure by filling a portion of the corresponding one the first trench and the second trench, the fill structure adjacent to and compositionally different from the source/drain liner. At operation 516, the process includes providing a source structure in the first trench, and a drain structure in the second trench, the source/drain liner being part of a corresponding one of the source structure and the drain structure. At operation 518, the process includes providing metal contact structures coupled to corresponding ones of the source structure and the drain structure.

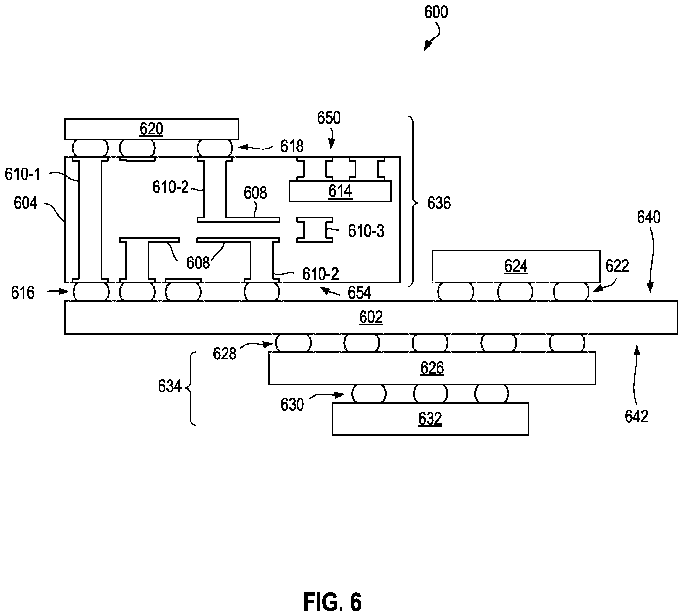

Fig. 6 is a cross-sectional side view of an integrated circuit device assembly 600 that may include one or more integrated circuit structures each including any of the GAA transistor devices described herein. The integrated circuit device assembly 600 includes a number of components disposed on a circuit board 602 (which may be a motherboard, system board, mainboard, etc.). The integrated circuit device assembly 600 includes components disposed on a first face 640 of the circuit board 602 and an opposing second face 642 of the circuit board 602; generally, components may be disposed on one or both faces 640 and 642. Any of the integrated circuit components discussed below with reference to the integrated circuit device assembly 600 may include an integrated circuit structure including transistor device embodiments as disclosed herein.

In some embodiments, the circuit board 602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 602. In other embodiments, the circuit board 602 may be a non-PCB substrate. The integrated circuit device assembly 600 illustrated in Fig. 6 includes a package-on-interposer structure 636 coupled to the first face 640 of the circuit board 602 by coupling components 616. The coupling components 616 may electrically and mechanically couple the package-on-interposer structure 636 to the circuit board 602, and may include solder balls (as shown in Fig. 6), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 636 may include an integrated circuit component 620 coupled to an interposer 604 by coupling components 618. The coupling components 618 may take any suitable form for the application, such as the forms discussed above with reference to the coupling components 616. Although a single integrated circuit component 620 is shown in Fig. 6, multiple integrated circuit components may be coupled to the interposer 604; indeed, additional interposers may be coupled to the interposer 604. The interposer 604 may provide an intervening substrate used to bridge the circuit board 602 and the integrated circuit component 620.

The integrated circuit component 620 may be a packaged or unpackaged integrated circuit product that includes one or more integrated circuit dies including transistor devices such as those shown in Figs. 9B and 9C. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 620, a single monolithic integrated circuit die comprises solder bumps attached to contacts on the die. The solder bumps allow the die to be directly attached to the interposer 604. The integrated circuit component 620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 620 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 604 may spread connections to a wider pitch or reroute a connection to a different connection. For example, the interposer 604 may couple the integrated circuit component 620 to a set of ball grid array (BGA) conductive contacts of the coupling components 616 for coupling to the circuit board 602. In the embodiment illustrated in Fig. 6, the integrated circuit component 620 and the circuit board 602 are attached to opposing sides of the interposer 604; in other embodiments, the integrated circuit component 620 and the circuit board 602 may be attached to a same side of the interposer 604. In some embodiments, three or more components may be interconnected by way of the interposer 604.

In some embodiments, the interposer 604 may be formed as a PCB, including multiple metal layers separated from one another by layers of dielectric material and interconnected by electrically conductive vias. In some embodiments, the interposer 604 may be formed of an epoxy resin, a fiberglass-reinforced epoxy resin, an epoxy resin with inorganic fillers, a ceramic material, or a polymer material such as polyimide. In some embodiments, the interposer 604 may be formed of alternate rigid or flexible materials that may include the same materials described above for use in a semiconductor substrate, such as silicon, germanium, and other group III-V and group IV materials. The interposer 604 may include metal interconnects 608 and vias 610, including but not limited to through hole vias 610-1 (that extend from a first face 650 of the interposer 604 to a second face 654 of the interposer 604), blind vias 610-2 (that extend from the first or second faces 650 or 654 of the interposer 604 to an internal metal layer), and buried vias 610-3 (that connect internal metal layers).

In some embodiments, the interposer 604 can comprise a silicon interposer. Through silicon vias (TSV) extending through the silicon interposer can connect connections on a first face of a silicon interposer to an opposing second face of the silicon interposer. In some embodiments, an interposer 604 comprising a silicon interposer can further comprise one or more routing layers to route connections on a first face of the interposer 604 to an opposing second face of the interposer 604.

The interposer 604 may further include embedded devices 614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 604. The package-on-interposer structure 636 may take the form of any of the package-on-interposer structures known in the art. In embodiments where the interposer is a non-printed circuit board

The integrated circuit device assembly 600 may include an integrated circuit component 624 coupled to the first face 640 of the circuit board 602 by coupling components 622. The coupling components 622 may take the form of any of the embodiments discussed above with reference to the coupling components 616, and the integrated circuit component 624 may take the form of any of the embodiments discussed above with reference to the integrated circuit component 620.

The integrated circuit device assembly 600 illustrated in Fig. 6 includes a package-on-package structure 634 coupled to the second face 642 of the circuit board 602 by coupling components 628. The package-on-package structure 634 may include an integrated circuit component 626 and an integrated circuit component 632 coupled together by coupling components 630 such that the integrated circuit component 626 is disposed between the circuit board 602 and the integrated circuit component 632. The coupling components 628 and 630 may take the form of any of the embodiments of the coupling components 616 discussed above, and the integrated circuit components 626 and 632 may take the form of any of the embodiments of the integrated circuit component 620 discussed above. The package-on-package structure 634 may be configured in accordance with any of the package-on-package structures known in the art.

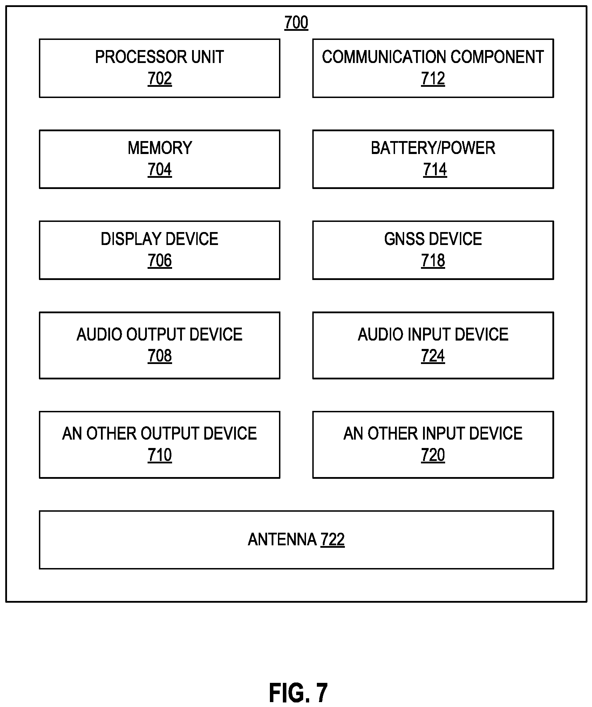

Fig. 7 is a block diagram of an example electrical device 700 that may include one or more of the transistor devices of embodiments disclosed herein. For example, any suitable ones of the components of the electrical device 700 may include one or more of the integrated circuit device assemblies 600, integrated circuit components 620, and/or transistor device embodiments disclosed herein. A number of components are illustrated in Fig. 7 as included in the electrical device 700, but any one or more of these components may be omitted or duplicated, as suitable for the application. In some embodiments, some or all of the components included in the electrical device 700 may be attached to one or more motherboards mainboards, or system boards. In some embodiments, one or more of these components are fabricated onto a single system-on-a-chip (SoC) die.

Additionally, in various embodiments, the electrical device 700 may not include one or more of the components illustrated in Fig. 7, but the electrical device 700 may include interface circuitry for coupling to the one or more components. For example, the electrical device 700 may not include a display device 706, but may include display device interface circuitry (e.g., a connector and driver circuitry) to which a display device 706 may be coupled. In another set of examples, the electrical device 700 may not include an audio input device 724 or an audio output device 708, but may include audio input or output device interface circuitry (e.g., connectors and supporting circuitry) to which an audio input device 724 or audio output device 708 may be coupled.

The electrical device 700 may include one or more processor units 702 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 700 may include a memory 704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 704 may include memory that is located on the same integrated circuit die as the processor unit 702. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 700 can comprise one or more processor units 702 that are heterogeneous or asymmetric to another processor unit 702 in the electrical device 700. There can be a variety of differences between the processing units 702 in a system in terms of a spectrum of metrics of merit including architectural, microarchitectural, thermal, power consumption characteristics, and the like. These differences can effectively manifest themselves as asymmetry and heterogeneity among the processor units 702 in the electrical device 700.

In some embodiments, the electrical device 700 may include a communication component 712 (e.g., one or more communication components). For example, the communication component 712 can manage wireless communications for the transfer of data to and from the electrical device 700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 712 may operate in accordance with other wireless protocols in other embodiments. The electrical device 700 may include one or more antennas, such as antenna 722 to facilitate wireless communications and/or to receive other wireless communications (such as AM or FM radio transmissions).

In some embodiments, the communication component 712 may manage wired communications, such as electrical, optical, or any other suitable communication protocols (e.g., IEEE 802.3 Ethernet standards). As noted above, the communication component 712 may include multiple communication components. For instance, a first communication component 712 may be dedicated to shorter-range wireless communications such as Wi-Fi or Bluetooth, and a second communication component 712 may be dedicated to longer-range wireless communications such as global positioning system (GPS), EDGE, GPRS, CDMA, WiMAX, LTE, EV-DO, or others. In some embodiments, a first communication component 712 may be dedicated to wireless communications, and a second communication component 712 may be dedicated to wired communications.

The electrical device 700 may include battery/power circuitry 714. The battery/power circuitry 714 may include one or more energy storage devices (e.g., batteries or capacitors) and/or circuitry for coupling components of the electrical device 700 to an energy source separate from the electrical device 700 (e.g., AC line power).

The electrical device 700 may include a display device 706 (or corresponding interface circuitry, as discussed above). The display device 706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 700 may include an audio output device 708 (or corresponding interface circuitry, as discussed above). The audio output device 708 may include any embedded or wired or wirelessly connected external device that generates an audible indicator, such speakers, headsets, or earbuds.

The electrical device 700 may include an audio input device 724 (or corresponding interface circuitry, as discussed above). The audio input device 724 may include any embedded or wired or wirelessly connected device that generates a signal representative of a sound, such as microphones, microphone arrays, or digital instruments (e.g., instruments having a musical instrument digital interface (MIDI) output). The electrical device 700 may include a Global Navigation Satellite System (GNSS) device 718 (or corresponding interface circuitry, as discussed above), such as a Global Positioning System (GPS) device. The GNSS device 718 may be in communication with a satellite-based system and may determine a geolocation of the electrical device 700 based on information received from one or more GNSS satellites, as known in the art.

The electrical device 700 may include another output device 710 (or corresponding interface circuitry, as discussed above). Examples of the other output device 710 may include an audio codec, a video codec, a printer, a wired or wireless transmitter for providing information to other devices, or an additional storage device.

The electrical device 700 may include another input device 720 (or corresponding interface circuitry, as discussed above). Examples of the other input device 720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 700 may have any desired form factor, such as a handheld or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 700 may be any other electronic device that processes data. In some embodiments, the electrical device 700 may comprise multiple discrete physical components. Given the range of devices that the electrical device 700 can be manifested as in various embodiments, in some embodiments, the electrical device 700 can be referred to as a computing device or a computing system.

Although an overview of embodiments has been described with reference to specific example embodiments, various modifications and changes may be made to these embodiments without departing from the broader scope of embodiments of the present disclosure. Such embodiments of the inventive subject matter may be referred to herein, individually or collectively, by the term "invention" merely for convenience and without intending to voluntarily limit the scope of this application to any single disclosure or inventive concept if more than one is, in fact, disclosed.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Although an overview of embodiments has been described with reference to specific example embodiments, various modifications and changes may be made to these embodiments without departing from the broader scope of embodiments of the present disclosure. Such embodiments of the inventive subject matter may be referred to herein, individually or collectively, by the term "invention" merely for convenience and without intending to voluntarily limit the scope of this application to any single disclosure or inventive concept if more than one is, in fact, disclosed.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

It will also be understood that, although the terms "first," "second," and so forth may be used herein to describe various elements, these elements should not be limited by these terms. These terms are only used to distinguish one element from another. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

In embodiments, the phrase "A is located on B" or "A is on B" means that at least a part of A is in direct physical contact or indirect physical contact (having one or more other features between A and B) with at least a part of B.

In the instant description, "A is adjacent to B" means that at least part of A is in direct physical contact with at least a part of B.

In the instant description, "B is between A and C" means that at least part of B is in or along a space separating A and C and that the at least part of B is in direct or indirect physical contact with A and C.

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," "according to some embodiments," "in accordance with embodiments," or "in embodiments," which may each refer to one or more of the same or different embodiments. Furthermore, the terms "comprising," "including," "having," and the like, as used with respect to embodiments of the present disclosure, are synonymous.

"Coupled" as used herein means that two or more elements are in direct physical contact, or that that two or more elements indirectly physically contact each other, but yet still cooperate or interact with each other (i.e. one or more other elements are coupled or connected between the elements that are said to be coupled with each other). The term "directly coupled" means that two or more elements are in direct contact.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn and Ni.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc, as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices. The term "signal" may refer to at least one current signal, voltage signal, magnetic signal, or data/clock signal. The meaning of "a," "an," and "the" include plural references. The meaning of "in" includes "in" and "on."

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors--BJT PNP/NPN, BiCMOS, CMOS, eFET, etc., may be used without departing from the scope of the disclosure. The term "MN" indicates an n-type transistor (e.g., NMOS, NPN BJT, etc.) and the term "MP" indicates a p-type transistor (e.g., PMOS, PNP BJT, etc.).

## Claims

1. An integrated circuit, IC, structure (260) including:
a substrate (202);
a transistor device (260') on the substrate (202), the transistor device (260') comprising:
a channel structure including a semiconductor material;
a gate stack (213) including a metal, the gate stack (213) on the channel structure;
a source structure (280a) in a first trench (217a) at a first side of the gate stack (213);
a drain structure (280b) in a second trench (217b) at a second side of the gate stack (213);
individual ones of the source structure (280a) and the drain structure (280b) including a source or drain, source/drain, liner (215) comprising a doped epitaxial layer conformal with a surface of a corresponding one of the first trench (217a) and the second trench (217b); and
a fill structure (282) filling a portion of a corresponding one the first trench (217a) and the second trench (217b), the fill structure (282) adjacent to and compositionally different from the source/drain liner (215); and
metal contact structures (230) coupled to respective ones of the source structure (280a) and the drain structure (280b),
wherein the doped epitaxial layer is a first doped epitaxial layer (244), the source/drain liner (215) including a second doped epitaxial layer (245) disposed on, conformal with and compositionally different from the first doped epitaxial layer (244), and
**characterized in that** the first doped epitaxial layer (244) includes boron doped silicon germanium and has an atomic percentage of germanium that is 50% or more, and the second doped epitaxial layer (245) includes boron doped germanium and has an atomic percentage of silicon that is from 0% to 5%,
wherein a doping concentration of boron in the second doped epitaxial layer (245) is more than a doping concentration of boron in the first doped epitaxial layer (244).

2. An integrated circuit, IC, device comprising least one IC (260) structure according to claim 1.

3. The IC device of claim 2, wherein individual ones of the metal contact structures (230) include the fill structure (282) and extend into corresponding ones of the first trench (217a) and the second trench (217b) to a depth below a lower surface (293) of the gate stack (213).

4. The IC structure of claim 3, wherein individual ones of the metal contact structures (230) extend into corresponding ones of the first trench (217a) and the second trench (217b) such that they are adjacent to the source/drain liner (215).

5. An integrated circuit, IC, device assembly (600) including:
a printed circuit board (602); and
a plurality of integrated circuit components attached to the printed circuit board, individual ones of the integrated circuit components including one or more integrated circuit structures according to claim 1.

6. The IC device assembly (600) of claim 5, wherein individual ones of the metal contact structures (230) include the fill structure (282) and extend into corresponding ones of the first trench (217a) and the second trench (217b) to a depth below a lower surface of the gate stack (213).

7. The IC device assembly (600) of claim 5, wherein individual ones of the source structure (280a) and the drain structure (280b) include the fill structure (282), the fill structure (282) including a doped epitaxial structure (290) disposed on the source/drain liner (215), the doped epitaxial structure (290) having a lower surface (293) conformal with an upper surface of the doped epitaxial layer, and an upper surface that is above a fifty percent depth location of the corresponding one of the first trench (217a) or the second trench (217b).

8. A method to fabricate an integrated circuit, IC, structure (260) including:
providing, on a substrate (202), an epitaxial layer including a semiconductor material;
etching the epitaxial layer to form a channel structure therefrom, etching including providing a first trench (217a) at a first side of the channel structure, and a second trench (217b) at a second side of the channel structure;
depositing, conformally with and on a surface of a corresponding one of the first trench (217a) and the second trench (217b), a source or drain, source/drain, liner (215) comprising a doped epitaxial layer;
depositing a sacrificial material in corresponding ones of the first trench (217a) and the second trench (217b) on the source/drain liner (215);
providing a gate stack (213) including metal on the channel structure;
removing the sacrificial material;
after removing the sacrificial material, providing a fill structure (282) by filling a portion of the corresponding one the first trench (217a) and the second trench (217b), the fill structure (282) adjacent to and compositionally different from the source/drain liner (215);
providing a source structure (280a) in the first trench (217a), and a drain structure (280b) in the second trench (217b), the source/drain liner being part of a corresponding one of the source structure (280a) and the drain structure (280b); and
providing metal contact structures (230) coupled to corresponding ones of the source structure (280a) and the drain structure (280b),
wherein the doped epitaxial layer is a first doped epitaxial layer (244), the source/drain liner (215) including a second doped epitaxial layer (245) disposed on, conformal with and compositionally different from the first doped epitaxial layer (244), and
**characterized in that** the first doped epitaxial layer (244) includes boron doped silicon germanium and has an atomic percentage of germanium that is 50% or more, and the second doped epitaxial layer (245) includes boron doped germanium and has an atomic percentage of silicon that is from 0% to 5%,
wherein a doping concentration of boron in the second doped epitaxial layer (245) is more than a doping concentration of boron in the first doped epitaxial layer (244).

## Patentansprüche

1. Integrierte Schaltungsstruktur, IS-Struktur, (260), Folgendes aufweisend:
ein Substrat (202);
eine Transistorvorrichtung (260') auf dem Substrat (202), die Transistorvorrichtung (260') Folgendes umfassend:
eine Kanalstruktur, die ein Halbleitermaterial aufweist;
einen Gate-Stapel (213), der ein Metall aufweist, wobei der Gate-Stapel (213) auf der Kanalstruktur angeordnet ist;
eine Source-Struktur (280a) in einem ersten Graben (217a) an einer ersten Seite des Gate-Stapels (213);
eine Drain-Struktur (280b) in einem zweiten Graben (217b) an einer zweiten Seite des Gate-Stapels (213);
einzelne Strukturen der Source-Struktur (280a) und der Drain-Struktur (280b), die eine Source- oder Drain-, Source-/Drain-, Auskleidung (215) aufweisen, die eine dotierte epitaxiale Schicht umfasst, die mit einer Oberfläche eines entsprechenden des ersten Grabens (217a) und des zweiten Grabens (217b) konform ist; und
eine Füllstruktur (282), die einen Abschnitt eines entsprechenden des ersten Grabens (217a) und des zweiten Grabens (217b) füllt, wobei die Füllstruktur (282) der Source-/Drain-Auskleidung (215) benachbart ist und in ihrer Zusammensetzung von dieser verschieden ist; und
Metallkontaktstrukturen (230), die mit jeweiligen der Source-Struktur (280a) und der Drain-Struktur (280b) verbunden sind,
wobei die dotierte epitaxiale Schicht eine erste dotierte epitaxiale Schicht (244) ist, wobei die Source-/Drain-Auskleidung (215) eine zweite dotierte epitaxiale Schicht (245) aufweist, die auf der ersten dotierten epitaxialen Schicht (244) angeordnet ist, mit dieser konform ist und in ihrer Zusammensetzung von dieser verschieden ist, und **dadurch gekennzeichnet, dass** die erste dotierte epitaxiale Schicht (244) mit Bor dotiertes Silizium-Germanium aufweist und ein Germanium-Atomprozent aufweist, das 50 % oder mehr beträgt, und die zweite dotierte epitaxiale Schicht (245) mit Bor dotiertes Germanium aufweist und ein Silizium-Atomprozent aufweist, das 0 % bis 5 % beträgt,
wobei eine Bor-Dotierungskonzentration in der zweiten dotierten epitaxialen Schicht (245) größer ist als eine Bor-Dotierungskonzentration in der ersten dotierten epitaxialen Schicht (244).

2. Integrierte Schaltungsvorrichtung, IS-Vorrichtung, die mindestens eine IS-Struktur (260) nach Anspruch 1 umfasst.

3. IS-Vorrichtung nach Anspruch 2, wobei einzelne der Metallkontaktstrukturen (230) die Füllstruktur (282) aufweisen und sich in entsprechende des ersten Grabens (217a) und des zweiten Grabens (217b) bis zu einer Tiefe unterhalb einer unteren Oberfläche (293) des Gate-Stapels (213) erstrecken.

4. IS-Struktur nach Anspruch 3, wobei sich einzelne der Metallkontaktstrukturen (230) in entsprechende des ersten Grabens (217a) und des zweiten Grabens (217b) erstrecken, so dass sie der Source-/Drain-Auskleidung (215) benachbart sind.

5. Integrierte Schaltungsvorrichtungsbaugruppe, IS-Vorrichtungsbaugruppe (600), Folgendes aufweisend:
eine Leiterplatte (602); und
eine Mehrzahl integrierter Schaltungskomponenten, die an der Leiterplatte befestigt sind, wobei einzelne der integrierten Schaltungskomponenten mindestens eine integrierte Schaltungsstruktur nach Anspruch 1 aufweisen.

6. IS-Vorrichtungsbaugruppe (600) nach Anspruch 5, wobei einzelne der Metallkontaktstrukturen (230) die Füllstruktur (282) aufweisen und sich in entsprechende des ersten Grabens (217a) und des zweiten Grabens (217b) bis zu einer Tiefe unterhalb einer unteren Oberfläche des Gate-Stapels (213) erstrecken.

7. IS-Vorrichtungsbaugruppe (600) nach Anspruch 5, wobei einzelne der Source-Struktur (280a) und der Drain-Struktur (280b) die Füllstruktur (282) aufweisen, wobei die Füllstruktur (282) eine dotierte epitaxiale Struktur (290) aufweist, die auf der Source-/Drain-Auskleidung (215) angeordnet ist, wobei die dotierte epitaxiale Struktur (290) eine untere Oberfläche (293), die mit einer oberen Oberfläche der dotierten epitaxialen Schicht konform ist, und eine obere Oberfläche aufweist, die über einem Tiefenort von fünfzig Prozent des entsprechenden des ersten Grabens (217a) oder des zweiten Grabens (217b) ist.

8. Verfahren zum Fertigen einer integrierten Schaltungsstruktur, IS-Struktur, (260), Folgendes aufweisend:
Bereitstellen einer epitaxialen Schicht, die ein Halbleitermaterial aufweist, auf einem Substrat (202);
Ätzen der epitaxialen Schicht, um daraus eine Kanalstruktur auszubilden, wobei Ätzen ein Bereitstellen eines ersten Grabens (217a) an einer ersten Seite der Kanalstruktur und eines zweiten Grabens (217b) an einer zweiten Seite der Kanalstruktur aufweist;
Abscheiden, auf einer Oberfläche eines entsprechenden des ersten Grabens (217a) und des zweiten Grabens (217b) und konform mit dieser, einer Source- oder Drain-, Source-/Drain-, Auskleidung (215), die eine dotierte epitaxiale Schicht umfasst;
Abscheiden eines Opfermaterials in entsprechenden des ersten Grabens (217a) und des zweiten Grabens (217b) auf der Source-/Drain-Auskleidung (215);
Bereitstellen eines Gate-Stapels (213), der Metall auf der Kanalstruktur aufweist;
Entfernen des Opfermaterials;
nach Entfernen des Opfermaterials, Bereitstellen einer Füllstruktur (282) durch Füllen eines Abschnitts des entsprechenden des ersten Grabens (217a) und des zweiten Grabens (217b), wobei die Füllstruktur (282) der Source-/Drain-Auskleidung (215) benachbart ist und in ihrer Zusammensetzung von dieser verschieden ist;
Bereitstellen einer Source-Struktur (280a) in dem ersten Graben (217a) und einer Drain-Struktur (280b) in dem zweiten Graben (217b), wobei die Source-/Drain-Auskleidung Teil einer entsprechenden der Source-Struktur (280a) und der Drain-Struktur (280b) ist; und
Bereitstellen von Metallkontaktstrukturen (230), die mit entsprechenden der Source-Struktur (280a) und der Drain-Struktur (280b) verbunden sind,
wobei die dotierte epitaxiale Schicht eine erste dotierte epitaxiale Schicht (244) ist, wobei die Source-/Drain-Auskleidung (215) eine zweite dotierte epitaxiale Schicht (245) aufweist, die auf der ersten dotierten epitaxialen Schicht (244) angeordnet ist, mit dieser konform ist und in ihrer Zusammensetzung von dieser verschieden ist, und **dadurch gekennzeichnet, dass** die erste dotierte epitaxiale Schicht (244) mit Bor dotiertes Silizium-Germanium aufweist und ein Germanium-Atomprozent aufweist, das 50 % oder mehr beträgt, und die zweite dotierte epitaxiale Schicht (245) mit Bor dotiertes Germanium aufweist und ein Silizium-Atomprozent aufweist, das 0 % bis 5 % beträgt,
wobei eine Bor-Dotierungskonzentration in der zweiten dotierten epitaxialen Schicht (245) größer ist als eine Bor-Dotierungskonzentration in der ersten dotierten epitaxialen Schicht (244).

## Revendications

1. Structure de circuit intégré, IC (260) comportant :
un substrat (202) ;
un dispositif transistor (260') sur le substrat (202), le dispositif transistor (260') comprenant :
une structure de canal comportant un matériau semi-conducteur ;
un empilement de grille (213) comportant un métal, l'empilement de grille (213) se trouvant sur la structure de canal ;
une structure de source (280a) dans une première tranchée (217a) sur un premier côté de l'empilement de grille (213) ;
une structure de drain (280b) dans une deuxième tranchée (217b) sur un deuxième côté de l'empilement de grille (213) ;
la structure de source (280a) et la structure de drain (280b) comportant individuellement un revêtement de source ou de drain, source/drain (215) comprenant une couche épitaxiale dopée enrobant une surface d'une tranchée correspondante parmi la première tranchée (217a) et la deuxième tranchée (217b) ; et
une structure de remplissage (282) remplissant une partie d'une tranchée correspondante parmi la première tranchée (217a) et la deuxième tranchée (217b), la structure de remplissage (282) étant adjacente au et différente en composition du revêtement de source/drain (215) ; et
des structures de contact métallique (230) couplées à des structures respectives parmi la structure de source (280a) et à la structure de drain (280b),
dans laquelle la couche épitaxiale dopée est une première couche épitaxiale dopée (244), le revêtement de source/drain (215) comportant une deuxième couche épitaxiale dopée (245) disposée sur, enrobant et différente en composition de la première couche épitaxiale dopée (244), et
**caractérisée en ce que** la première couche épitaxiale dopée (244) comporte du silicium-germanium dopé au bore et a un pourcentage atomique de germanium qui est de 50 % ou plus, et la deuxième couche épitaxiale dopée (245) comporte du germanium dopé au bore et a un pourcentage atomique de silicium qui est de 0 % à 5 %,
dans laquelle une concentration de dopage au bore dans la deuxième couche épitaxiale dopée (245) est supérieure à une concentration de dopage au bore dans la première couche épitaxiale dopée (244).

2. Dispositif de circuit intégré, IC, comprenant au moins une structure IC (260) selon la revendication 1.

3. Dispositif IC selon la revendication 2, dans lequel les structures de contact métallique (230) comportent individuellement la structure de remplissage (282) et s'étendent à l'intérieur de tranchées correspondantes parmi la première tranchée (217a) et la deuxième tranchée (217b) jusqu'à une profondeur en dessous d'une surface inférieure (293) de l'empilement de grille (213).

4. Structure IC selon la revendication 3, dans laquelle les structures de contact métallique (230) s'étendent individuellement à l'intérieur de tranchées correspondantes parmi la première tranchée (217a) et la deuxième tranchée (217b) de telle sorte qu'elles sont adjacentes au revêtement de source/drain (215).

5. Ensemble dispositif de circuit intégré, IC (600) comportant :
un circuit imprimé nu (602) ; et
une pluralité de composants de circuit intégré attachés au circuit imprimé nu, les composants de circuit intégré comportant individuellement une ou plusieurs structures de circuit intégré selon la revendication 1.

6. Ensemble dispositif IC (600) selon la revendication 5, dans lequel les structures de contact métallique (230) comportent individuellement la structure de remplissage (282) et s'étendent à l'intérieur de tranchées correspondantes parmi la première tranchée (217a) et la deuxième tranchée (217b) jusqu'à une profondeur en dessous d'une surface inférieure de l'empilement de grille (213).

7. Ensemble dispositif IC (600) selon la revendication 5, dans lequel la structure de source (280a) et la structure de drain (280b) comportent individuellement la structure de remplissage (282), la structure de remplissage (282) comportant une structure épitaxiale dopée (290) disposée sur le revêtement de source/drain (215), la structure épitaxiale dopée (290) ayant une surface inférieure (293) enrobant une surface supérieure de la couche épitaxiale dopée, et une surface supérieure qui est au-dessus d'un emplacement à cinquante pour cent de la profondeur de la tranchée correspondante parmi la première tranchée (217a) et la deuxième tranchée (217b).

8. Procédé de fabrication d'une structure de circuit intégré, IC (260) comportant :
l'obtention, sur un substrat (202), d'une couche épitaxiale comportant un matériau semi-conducteur ;
la gravure de la couche épitaxiale pour former une structure de canal à partir de celle-ci, la gravure comportant l'obtention d'une première tranchée (217a) sur un premier côté de la structure de canal, et d'une deuxième tranchée (217b) sur un deuxième côté de la structure de canal ;
le dépôt, de façon enrobante et sur une surface d'une tranchée correspondante parmi la première tranchée (217a) et la deuxième tranchée (217b), d'un revêtement de source ou de drain, source/drain (215) comprenant une couche épitaxiale dopée ;
le dépôt d'un matériau sacrificiel dans des tranchées correspondantes parmi la première tranchée (217a) et la deuxième tranchée (217b) sur le revêtement de source/drain (215) ;
l'obtention d'un empilement de grille (213) comportant un métal sur la structure de canal ;
le retrait du matériau sacrificiel ;
après le retrait du matériau sacrificiel, l'obtention d'une structure de remplissage (282) par remplissage d'une partie de la tranchée correspondante parmi la première tranchée (217a) et la deuxième tranchée (217b), la structure de remplissage (282) étant adjacente au et différente en composition du revêtement de source/drain (215) ;
l'obtention d'une structure de source (280a) dans la première tranchée (217a), et d'une structure de drain (280b) dans la deuxième tranchée (217b), le revêtement de source/drain faisant partie d'une structure correspondante parmi la structure de source (280a) et la structure de drain (280b) ; et
l'obtention de structures de contact métallique (230) couplées à des structures correspondantes parmi la structure de source (280a) et la structure de drain (280b),
dans lequel la couche épitaxiale dopée est une première couche épitaxiale dopée (244), le revêtement de source/drain (215) comportant une deuxième couche épitaxiale dopée (245) disposée sur, enrobant et différente en composition de la première couche épitaxiale dopée (244), et
**caractérisé en ce que** la première couche épitaxiale dopée (244) comporte du silicium-germanium dopé au bore et a un pourcentage atomique de germanium qui est de 50 % ou plus, et la deuxième couche épitaxiale dopée (245) comporte du germanium dopé au bore et a un pourcentage atomique de silicium qui est de 0 % à 5 %,
dans lequel une concentration de dopage au bore dans la deuxième couche épitaxiale dopée (245) est supérieure à une concentration de dopage au bore dans la première couche épitaxiale dopée (244).
